(19)

Europäisches
Patentamt
European
Patent Office
Office européen
des brevets

(11) **EP 4 283 249 A1**

(12) **EUROPEAN PATENT APPLICATION**
published in accordance with Art. 153(4) EPC

(43) Date of publication:
**29.11.2023 Bulletin 2023/48**

(21) Application number: **21920627.3**

(22) Date of filing: **16.09.2021**

(51) International Patent Classification (IPC):
***G01B 11/00*** (2006.01)      ***G03F 9/00*** (2006.01)

(86) International application number:
**PCT/CN2021/118791**

(87) International publication number:
**WO 2022/156249 (28.07.2022 Gazette 2022/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.01.2021 CN 202110084779**

(71) Applicant: **Institute Of Microelectronics,
Chinese Academy Of Sciences
Beijing 100029 (CN)**

(72) Inventors:
• **LI, Jing
  Beijing 100029 (CN)**
• **YANG, Guanghua
  Beijing 100029 (CN)**
• **DING, Minxia
  Beijing 100029 (CN)**
• **FENG, Lei
  Beijing 100029 (CN)**

(74) Representative: **Hoffmann Eitle
Patent- und Rechtsanwälte PartmbB
Arabellastraße 30
81925 München (DE)**

(54) **METHOD FOR REDUCING IMPACT OF PHASE GRATING ASYMMETRY ON POSITION
MEASUREMENT PRECISION**

(57)      A method of reducing an impact of phase grating asymmetry on a position measurement accuracy includes: determining an asymmetry change range according to a phase grating design value and a processing accuracy, and then determining an asymmetric grating structure; establishing an asymmetric grating simulation model; inputting the asymmetric grating structure into the asymmetric grating simulation model, and simulating a position error curve of each diffraction order within the asymmetry change range; and determining a weight of each diffraction order according to an obtained difference in position error of each diffraction order, so as to reduce an impact of an asymmetric change. Without a need to measure the morphology of the grating, but only by determining the asymmetry change range of the grating according to the processing accuracy, the impact of asymmetry change within the range on the position measurement accuracy may be reduced.

| A change range of an asymmetric grating structure is determined |
| :---: |
| ↓ |
| An asymmetric grating simulation model is established |
| ↓ |
| A position error of each diffraction order is simulated |
| ↓ |
| A weight of each diffraction order is obtained |

FIG. 1

EP 4 283 249 A1

**Description**

TECHNICAL FIELD

The present disclosure relates to the technical fields of semiconductors, integrated circuits, and precision measurement, and in particular to a method of reducing an impact of phase grating asymmetry on a position measurement accuracy.

BACKGROUND

Phase grating position measurement technology has the characteristics of high measurement accuracy and less environmental impact, which is widely used in the fields of integrated circuits, precision processing, and precision measurement. This technology uses spatially coherent light to irradiate a phase grating to generate diffraction beams at all orders, and enables +m diffraction order and - m diffraction order to interfere, then scans the phase grating to generate a measurement signal with sine change, and finally obtains the position information of the grating by fitting the measurement signal. With the continuous development of application fields, especially the continuous shrinking of technological nodes in the field of integrated circuits, higher requirements are put forward for the measurement accuracy of a grating position sensor. However, a phase grating structure changes due to the impact of etching, deposition, chemical mechanical polishing, and a temperature change during the processing and subsequent processing of the phase grating. According to a principle of phase grating position measurement, an asymmetric change in the grating structure leads to a measurement error. Therefore, it is desired to analyze the impact of grating asymmetry on the measurement accuracy and reduce such impact.

When analyzing the impact of grating asymmetry on the position measurement accuracy, a scanning electron microscope and the like are generally used to accurately measure a morphology of the grating, and then a diffraction field of the asymmetric grating is calculated by rigorously solving Maxwell's equations, such as Rigorous Coupled Wave Analysis (RCWA) or Finite Difference Time Domain (FDTD), so that the impact of asymmetry on the position measurement accuracy may be obtained, and the impact of asymmetry on the position measurement accuracy may be further reduced. However, different grating marks have different asymmetries, and the same grating mark may also result in different asymmetric changes due to factors such as clamping. Meanwhile, the scanning electron microscopy has a strict environmental requirement and a slow measurement speed, and is destructive. Although the method of rigorously solving Maxwell's equations has a high accuracy, it takes a long time. Therefore, the method requires a lot of time and is expensive.

SUMMARY

In view of the above, the main objective of the present disclosure is to provide a method of reducing an impact of phase grating asymmetry on a position measurement accuracy, so as to partially solve at least one of the above-mentioned technical problems.

In order to achieve the above-mentioned objectives, as an aspect of the present disclosure, there is provided a method of reducing an impact of phase grating asymmetry on a position measurement accuracy, including:

determining an asymmetry change range according to a phase grating design value and a processing accuracy, and then determining an asymmetric grating structure;
establishing an asymmetric grating simulation model;
inputting the asymmetric grating structure into the asymmetric grating simulation model, and simulating a position error curve of each diffraction order within the asymmetry change range; and
determining a weight of each diffraction order according to an obtained difference in position error of each diffraction order, so as to reduce an impact of an asymmetric change.

The establishing the asymmetric grating simulation model includes:

deducing, according to a principle of phase grating position measurement, a calculation equation for the impact of asymmetry on the measurement accuracy;
establishing, according to a scalar diffraction theory, an asymmetric grating model to obtain a diffraction field of an asymmetric grating, and then obtaining the impact of asymmetry on the position measurement accuracy according to the calculation equation.

The method further includes a step for verification, and the step for verification includes verifying a corrected position error curve, so as to determine the weight is valid within the determined asymmetry change range.

The principle of phase grating position measurement is: an incident beam with a wavelength λ is vertically incident on a phase grating to generate a diffraction beam at each order, +m diffraction order and -m diffraction order are interfered by an optical module; a periodic measurement signal is generated by scanning the phase grating; and position information of the phase grating is obtained from the measurement signal.

The calculation equation for the impact of asymmetry on the measurement accuracy is:

$$V = \frac{2|A_m||A_{-m}|}{|A_{-m}|^2 + |A_{-m}|^2}, \quad \Delta x_m = \frac{\Delta\varphi_m}{4m\pi}d;$$

wherein $V$ is a signal contrast ratio, $A_m$ is an amplitude of the $+m^{th}$ diffraction order, $A_{-m}$ is an amplitude of the $-m^{th}$ diffraction order, $\Delta x_m$ is a position error, $\Delta\varphi_m$ is a phase after grating diffraction, and $d$ is a grating period.

The obtaining the diffraction field of the asymmetric grating includes analyzing a diffraction field of a top tilted grating, and then deducing the diffraction field of the asymmetric grating.

The diffraction field of the top tilted grating is expressed as:

$$E_m(h, \Delta h, f) = -\frac{\sin(m\pi f)}{m\pi} + \frac{\sin(m\pi f + 2\pi\Delta h/\lambda)}{m\pi + 2\pi\Delta h/(f\lambda)}\exp(-j4\pi h/\lambda)$$

wherein $h$ is a height of a grating ridge center, $\Delta h$ is an asymmetric height, $f$ is a duty cycle defined as $l/d$, $d$ is a grating period, and $l$ is a width of the grating ridge.

The asymmetric grating model includes a top, a bottom, a sidewall, and a vertex angle each having symmetry.

A ridge of the asymmetric grating model is divided into four parts, G1, G2, G3, and G4 respectively, and the diffraction field of the asymmetric grating is expressed as:

$$E_m^G = E_m^{G1} + E_m^{G2} + E_m^{G3} + E_m^{G4}$$

wherein $E_m^{G1}$, $E_m^{G2}$, $E_m^{G3}$ and $E_m^{G4}$ are diffraction fields of phase gratings composed of G1, G2, G3, and G4, respectively;

$$\begin{cases} E_m^{G1} = E_m(h_1/2, -h_1, f_1)\exp\left(-j\frac{2m\pi}{d}x_1\right), \\ E_m^{G2} = E_m((h_1+h_2)/2, h_1-h_2, f_2)\exp\left(-j\frac{2m\pi}{d}x_2\right), \\ E_m^{G3} = E_m((h_2+h_3)/2, h_2-h_3, f_3)\exp\left(-j\frac{2m\pi}{d}x_3\right), \\ E_m^{G4} = E_m(h_4, 0, f_4)\exp\left(-j\frac{2m\pi}{d}x_4\right), \end{cases}$$

wherein $h_1$, $h_2$, $h_3$ and $h_4$ represent heights of grating ridges in G1, G2, G3, and G4, respectively, $x_1$, $x_2$, $x_3$, and $x_4$ represent center positions of G1, G2, G3, and G4, respectively, and $f_1$, $f_2$, $f_3$, and $f_4$ represent duty cycles of G1, G2, G3, and G4, respectively.

A weight vector $\{w_m\}$ of the diffraction order is orthogonal to a position error vector $\{\Delta x_m\}$, and a sum of $w_m$ is 1, so as to reduce an asymmetric position error.

Based on the above-mentioned technical solution, it may be seen that the method of reducing an impact of phase grating asymmetry on the position measurement accuracy in the present disclosure has at least part of following beneficial effects with respect to the prior art.

The method proposed by the present disclosure does not require measuring the morphology of the grating, but only needs to determine the asymmetry change range of the grating according to the processing accuracy, so as to reduce the impact of asymmetry change within the range on the position measurement accuracy.

The method proposed by the present disclosure has strong process adaptability. Different asymmetries are caused by different process flows, and the asymmetries at different positions on the same silicon wafer are also inconsistent. However, the method may reduce the impact of asymmetry change within the range on the position measurement accuracy according to the change range.

The method proposed by the present disclosure has low cost and strong real-time performance. Since the method does not require additional hardware to complete testing, the method avoids measuring asymmetry by means of scanning electron microscopy and process testing verification, thereby reducing costs. In addition, since the asymmetry change range may be determined in advance according to the process flow and the processing accuracy, thereby reducing the impact of asymmetry on the position measurement accuracy, the method has strong real-time performance.

## BRIEF DESCRIPTION OF THE DRAWINGS

For a more complete understanding of the present disclosure and its advantages, reference is now made to the following description in combination with the accompanying drawings.

FIG. 1 shows a schematic flowchart of a method of reducing an impact of phase grating asymmetry on a position measurement accuracy of the present disclosure.
FIG. 2 shows a schematic diagram of determining an asymmetric grating structure.
FIG. 3 shows a schematic diagram of a top tilted grating structure within a period.
FIG. 4 shows a schematic diagram of an asymmetric grating structure.
FIG. 5 shows a schematic diagram of a decomposition of a mark structure.
FIG. 6 shows a position error of each diffraction order when a top tilt asymmetry changes in a range of [-30 nm, 30 nm].
FIG. 7 shows a position error curve when a top tilt asymmetry changes in a range of [-30 nm, 30 nm] after assigning weights to measurement positions of different diffraction orders.

## DETAILED DESCRIPTION OF EMBODIMENTS

In order to make the objectives, technical solutions, and advantages of the present disclosure more apparent and understandable, the present disclosure is further described in detail in combination with specific embodiments and with reference to the accompanying drawings.

The present disclosure proposes a method of reducing an impact of phase grating asymmetry on the position measurement accuracy. The method first determines an approximate morphology of a grating according to a design value of a phase grating and a range of grating processing. Then, according to the scalar diffraction theory, a grating analysis model is established to obtain the impact of asymmetric change on the measurement accuracy within the processing range. According to sensitivity differences of different diffraction orders to the asymmetric change, weights are assigned to measurement positions of different diffraction orders to reduce the impact of asymmetry on the position measurement accuracy. The method does not require measuring the morphology of the grating, but only needs to determine the asymmetry change range of the grating according to a processing accuracy, so as to reduce the impact of asymmetry change within the range on the position measurement accuracy.

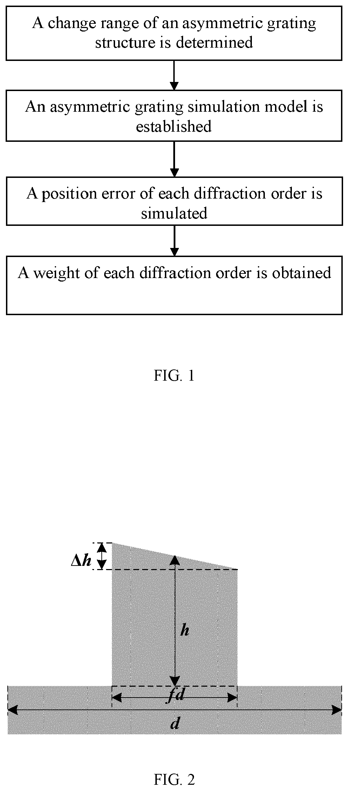

As shown in FIG. 1, a schematic flowchart of a method of reducing an impact of phase grating asymmetry on a position measurement accuracy includes following steps.

### 1. A change range of an asymmetric grating structure is determined.

According to a phase grating design value and a processing accuracy, an asymmetry change range is determined, as shown in FIG. 2. For example, a grating design period $d$ = 16 $\mu$m, a groove depth $h$ = 200 nm, and a gating ridge width $fd$ = 8 $\mu$m. According to the processing accuracy, assuming that the grating only has the asymmetry with a top tilt, a range of asymmetry of the top tilt is determined to be $\Delta h \in$ [-30 nm, 30 nm].

### 2. An asymmetric grating simulation model is established.

Firstly, according to a principle of phase grating position measurement, a calculation equation for an impact of asymmetry on the measurement accuracy is deduced. Then, according to a scalar diffraction theory, an asymmetric grating model is established to obtain a diffraction field of an asymmetric grating, and then the impact of asymmetry on the position measurement accuracy is obtained according to the calculation equation.

(1) The impact of asymmetry on the measurement accuracy.

A principle of a phase grating position sensor is: an incident beam with a wavelength $\lambda$ is vertically incident on the phase grating to generate a diffraction beam at each order, and +m diffraction order and -m diffraction order are interfered by an optical module. A periodic measurement signal is generated by scanning the phase grating. Position information of the phase grating is obtained from the measurement signal.

Assuming a position of the phase grating is $x_0$, the incident beam is a parallel beam with a unit amplitude, and an initial phase is 0, then a complex amplitude of the $+m^{th}$ diffraction order is:

$$E_m = A_m \exp\left\{ j\left[ \frac{2m\pi}{d}(x - x_0) + \varphi_m \right] \right\}, \quad (1)$$

$A_m$ is an amplitude of the $+m^{th}$ diffraction order, $\varphi_m$ is a phase after grating diffraction, $d$ is a grating period, and $x$ is a scanning motion position.

A complex amplitude of the $-m^{th}$ diffraction order is:

$$E_{-m} = A_{-m} \exp\left\{ j\left[ -\frac{2m\pi}{d}(x - x_0) + \varphi_{-m} \right] \right\}, \quad (2)$$

$A_{-m}$ is an amplitude of the $-m^{th}$ diffraction order, $\varphi_{-m}$ is a phase after grating diffraction. An interference light intensity is:

$$I_m(x) = \left|A_m\right|^2 + \left|A_{-m}\right|^2 + 2\left|A_m\right|\left|A_{-m}\right|\cos\left[ \frac{4m\pi}{d}(x - x_0) + (\varphi_m - \varphi_{-m}) \right], \quad (3)$$

A contrast ratio of the measurement signal is:

$$V = \frac{2\left|A_m\right|\left|A_{-m}\right|}{\left|A_{-m}\right|^2 + \left|A_{-m}\right|^2} \quad (4)$$

Let $\Delta\varphi_m = \varphi_m - \varphi_{-m}$, then the position of the grating is:

$$x_0' = x_0 + \frac{\Delta\varphi_m}{4m\pi}d \quad (5)$$

When the phase grating is a symmetric grating, $A_m = A_{-m}$ and $\varphi_m = \varphi_{-m}$, then equation (5) is expressed as:

$$x_0' = x_0 \quad (6)$$

At this point, the contrast ratio $V$ of the measurement signal is 1, and the position $x_0$ of the grating may be accurately obtained.

When the phase grating is an asymmetric grating, $A_m \neq A_{-m}$ and $\varphi_m \neq \varphi_{-m}$, then a resulting position error is:

$$\Delta x_m = \frac{\Delta \varphi_m}{4m\pi} d \quad (7)$$

Therefore, when the phase grating is the asymmetric grating, not only the contrast ratio $V$ of the measurement signal is reduced, but also the measurement position error is caused.

(2) Asymmetric grating model.

In order to analyze the impact of asymmetry on the measurement accuracy, it is desired to obtain a form of a diffraction field of the asymmetric grating. According to the scalar diffraction theory, the method first analyzes a diffraction field of the top tilted grating, and then deduces the diffraction field of any asymmetric grating.

**A. Top tilted asymmetric diffraction field.**

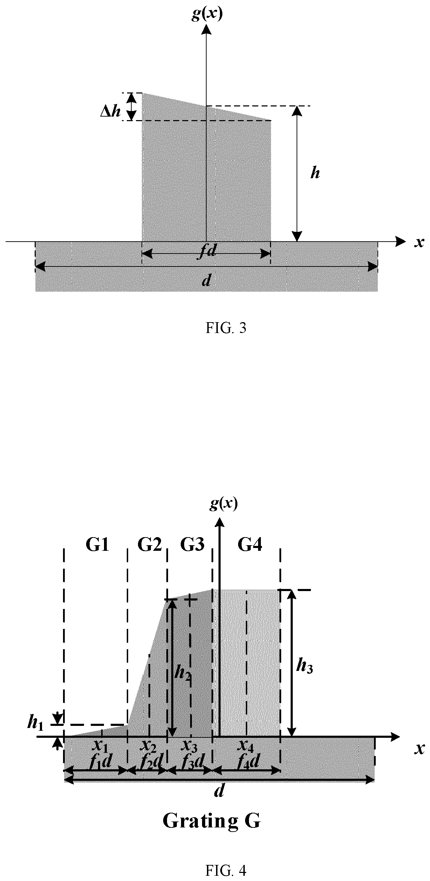

A top tilted asymmetric grating structure is shown in FIG. 3. $d$ is a grating period, $l$ is a width of the gating ridge, $f$ is a duty cycle and defined as $l/d$, $h$ is a height of a grating ridge center, and $\Delta h$ is an asymmetric height. It is assumed that the grating has infinite periods along the x-axis and extends infinitely perpendicular to the plane of the paper.
A coordinate system as shown in FIG. 3 is established, and the grating structure is expressed as:

$$g(x) = \begin{cases} 0, & nd + f\,d/2 < |x| \le nd + d/2 \\ h - x \cdot \Delta h / fd, & |x| \le nd + f\,d/2 \end{cases} \quad (8)$$

$n$ is a positive integer. A reflection function of the grating may be expressed as:

$$R(x) = \begin{cases} r, & nd + fd/2 < |x| \le nd + d/2 \\ r \exp\left[ -\mathrm{j}\frac{2\pi}{\lambda}(h - x\Delta h / fd) \right], & |x| \le nd + fd/2 \end{cases} \quad (9)$$

$\lambda$ is an incident wavelength, and $r$ is a reflection coefficient of a grating material. According to the scalar diffraction theory, when the incident beam is a plane wave with a unit amplitude, the diffraction field of the $m^{th}$ diffraction order may be expressed as:

$$E_m = \frac{1}{d} \int_{-d/2}^{d/2} R(x) \exp\left( -\mathrm{j}\frac{2m\pi}{d} x \right) \mathrm{d}x, \quad (10)$$

By substituting equation (9) into equation (10), it may be obtained that:

$$E_m(h, \Delta h, f) = -\frac{\sin(m\pi f)}{m\pi} + \frac{\sin(m\pi f + 2\pi\Delta h / \lambda)}{m\pi + 2\pi\Delta h / (f\lambda)} \exp(-\mathrm{j}4\pi h / \lambda) \quad (11)$$

$m \ne 0$.

**B. Asymmetric grating diffraction field.**

It is assumed that each of the bottom, the sidewall, and the vertex angle of the asymmetric grating G is asymmetric, as shown in FIG. 4. The entire ridge are divided into four parts, G1, G2, G3, and G4 respectively, center positions of G1, G2, G3, and G4 are $x_1$, $x_2$, $x_3$, and $x_4$ respectively, and the widths are $f_1d$, $f_2d$, $f_3d$, and $f_4d$, respectively.

According to the Fourier's theorem, a diffraction field $E_m^G$ of the grating G may be expressed as:

$$E_m^G = E_m^{G1} + E_m^{G2} + E_m^{G3} + E_m^{G4} \quad (12)$$

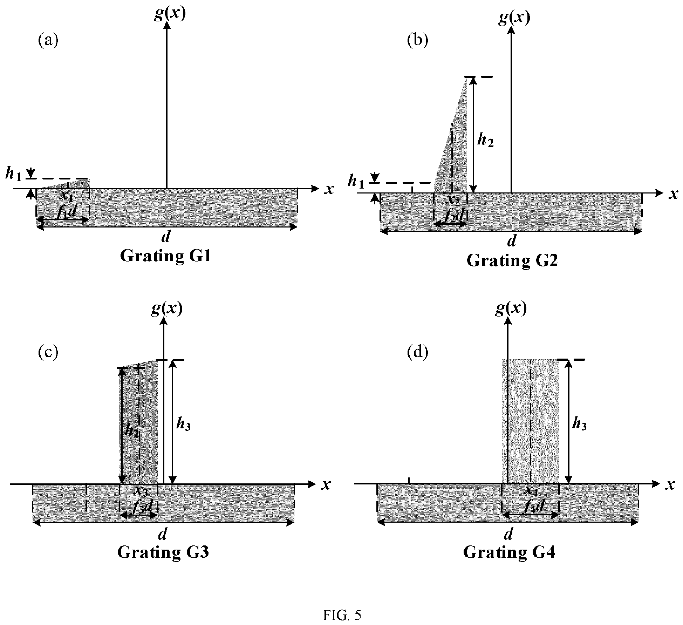

$E_m^{G1}$, $E_m^{G2}$, $E_m^{G3}$ and $E_m^{G4}$ are diffraction fields of phase gratings composed of G1, G2, G3, and G4, respectively, as shown in FIG. 5. $E_m^{G1}$, $E_m^{G2}$, $E_m^{G3}$ and $E_m^{G4}$ may be calculated by a diffraction field $E_m$ of the top tilt mark. According to the Fourier translation theorem, $E_m^{G1}$, $E_m^{G2}$, $E_m^{G3}$ and $E_m^{G4}$ may be expressed as:

$$\begin{cases} E_m^{G1} = E_m\left(h_1/2, -h_1, f_1\right)\exp\left(-\mathrm{j}\frac{2m\pi}{d}x_1\right), \\[2mm] E_m^{G2} = E_m\left((h_1+h_2)/2, h_1-h_2, f_2\right)\exp\left(-\mathrm{j}\frac{2m\pi}{d}x_2\right), \\[2mm] E_m^{G3} = E_m\left((h_2+h_3)/2, h_2-h_3, f_3\right)\exp\left(-\mathrm{j}\frac{2m\pi}{d}x_3\right), \\[2mm] E_m^{G4} = E_m\left(h_3, 0, f_4\right)\exp\left(-\mathrm{j}\frac{2m\pi}{d}x_4\right), \end{cases} \quad (13)$$

By substituting equation (11) and equation (13) into equation (12), the diffraction field $E_m^G$ of the grating G may be calculated. By using the same method, any asymmetric grating diffraction field may be obtained, and then the signal contrast ratio $V$ and the position error $\Delta x$ may be calculated by using equation (4) and equation (7).

**3. The position error of each diffraction order is simulated.**

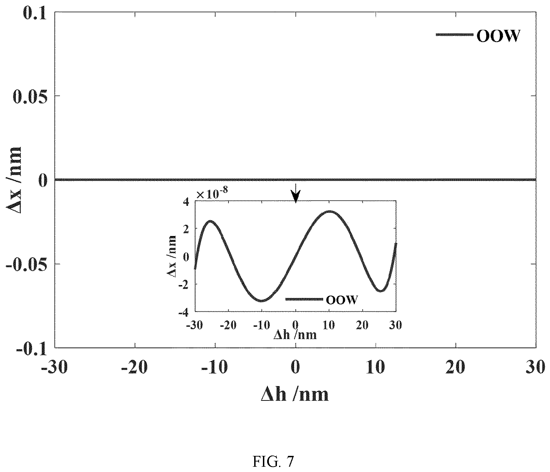

According to the equation in step 2, the position error of each diffraction order may be obtained by simulation when the top tilt asymmetry changes in a range of [-30 nm, 30 nm], as shown in FIG. 7. It may be seen that when the asymmetry changes, there are differences in the position errors of each diffraction order. The higher the diffraction order, the smaller the position error $\Delta x$ caused by the asymmetry; and the greater the asymmetry, the greater the position error of each diffraction order.

**4. The weight of each diffraction order is obtained.**

In order to improve the measurement accuracy, it is desired to control the position error caused by asymmetry. According to equation (7), the position error $\Delta x$ is a function of diffraction order $m$, and thus different $m$ has different $\Delta x$. Therefore, $\Delta x$ caused by the asymmetry may be reduced according to the difference.

Assuming that a position measurement sensor may collect measurement signals from the 1st diffraction order to the nth diffraction order, each diffraction order $m$ results in a position error of $\Delta x_m$, and an actual position of the grating is $x_0$, then the measurement result of the $m^{th}$ diffraction order is:

$$x_m = x_0 + \Delta x_m \quad (14)$$

Let a measurement result $x$ of the grating position be:

$$x = \sum_{m=1}^{n} w_m x_m \quad (15)$$

By substituting equation (14) into equation (15), it may be obtained that:

$$x = x_0 \sum_{m=1}^{n} w_m + \sum_{m=1}^{n} w_m \Delta x_m \quad (16)$$

Therefore, when there is no position error, i.e., $x = x_0$, it is required that:

$$\begin{cases} \sum_{m=1}^{n} w_m = 1, \\ \sum_{m=1}^{n} w_m \Delta x_m = 0, \end{cases} \quad (17)$$

Therefore, in order to reduce an asymmetric position error, it is desired that a weight vector $\{w_m\}$ of the diffraction order is orthogonal to a position error vector $\{\Delta x_m\}$, and a sum of $w_m$ is guaranteed to be 1. Based on the method, it may be determined that $\{w_m\}$ = {0, 0.0817, -0.8872, 0.5107, 1.2947}, where m = 1, 3, 5, 7, 9.

### 5. Verification.

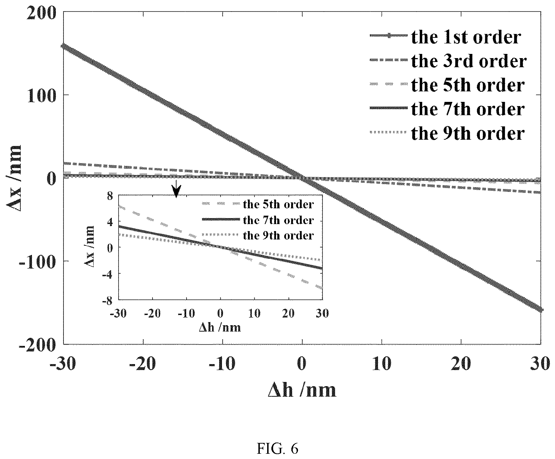

Using the weight, the corrected position error is shown in FIG. 6. When the top tilt asymmetry changes within a range of [-30 nm, 30 nm], the maximum position error is less than $4 \times 10^{-8}$ nm, which may be ignored.

The specific embodiments described above further explain objectives, technical solutions and beneficial effects of the present disclosure in detail. It should be understood that the specific embodiments described above are only specific embodiments of the present disclosure, and should not be used to limit the present disclosure. Any modifications, equivalent substitutions, improvements and the like made within the spirit and principle of the present disclosure should be included in the protection scope of the present disclosure.

### Claims

1.  A method of reducing an impact of phase grating asymmetry on a position measurement accuracy, comprising:

    determining an asymmetry change range according to a phase grating design value and a processing accuracy, and then determining an asymmetric grating structure;
    establishing an asymmetric grating simulation model;
    inputting the asymmetric grating structure into the asymmetric grating simulation model, and simulating a position error curve of each diffraction order within the asymmetry change range; and
    determining a weight of each diffraction order according to an obtained difference in position error of each diffraction order, so as to reduce an impact of an asymmetric change.

2.  The method according to claim 1, wherein the establishing the asymmetric grating simulation model comprises:

    deducing, according to a principle of phase grating position measurement, a calculation equation for the impact of asymmetry on the measurement accuracy;
    establishing, according to a scalar diffraction theory, an asymmetric grating model to obtain a diffraction field of an asymmetric grating, and then obtaining the impact of asymmetry on the position measurement accuracy according to the calculation equation.

3.  The method according to claim 1, further comprising a step for verification, wherein the step for verification comprises verifying a corrected position error curve, so as to determine the weight is valid within the determined asymmetry change range.

4. The method according to claim 2, wherein the principle of phase grating position measurement is: an incident beam with a wavelength $\lambda$ is vertically incident on a phase grating to generate a diffraction beam at each order, +m diffraction order and -m diffraction order are interfered by an optical module; a periodic measurement signal is generated by scanning the phase grating; and position information of the phase grating is obtained from the measurement signal.

5. The method according to claim 2, wherein the calculation equation for the impact of asymmetry on the measurement accuracy is:

$$V = \frac{2|A_m||A_{-m}|}{|A_{-m}|^2 + |A_{-m}|^2} , \quad \Delta x_m = \frac{\Delta \varphi_m}{4m\pi} d ;$$

wherein $V$ is a signal contrast ratio, $A_m$ is an amplitude of the $+m^{th}$ diffraction order, $A_{-m}$ is an amplitude of the $-m^{th}$ diffraction order, $\Delta x_m$ is a position error, $\Delta \varphi_m$ is a phase after grating diffraction, and $d$ is a grating period.

6. The method according to claim 2, wherein the obtaining the diffraction field of the asymmetric grating comprises analyzing a diffraction field of a top tilted grating, and then deducing the diffraction field of the asymmetric grating.

7. The method according to claim 6, wherein the diffraction field of the top tilted grating is expressed as:

$$E_m\left(h, \Delta h, f\right) = -\frac{\sin\left(m\pi f\right)}{m\pi} + \frac{\sin\left(m\pi f + 2\pi\Delta h/\lambda\right)}{m\pi + 2\pi\Delta h/\left(f\lambda\right)} \exp\left(-\mathrm{j}4\pi h/\lambda\right) ;$$

wherein $h$ is a height of a grating ridge center, $\Delta h$ is an asymmetric height, $f$ is a duty cycle defined as $l/d$, $d$ is a grating period, and $l$ is a width of the grating ridge.

8. The method according to claim 2, wherein the asymmetric grating model comprises a top, a bottom, a sidewall, and a vertex angle each having symmetry.

9. The method according to claim 8, wherein a ridge of the asymmetric grating model is divided into four parts, G1, G2, G3, and G4 respectively, and the diffraction field of the asymmetric grating is expressed as:

$$E_m^G = E_m^{G1} + E_m^{G2} + E_m^{G3} + E_m^{G4} ;$$

wherein $E_m^{G1}$, $E_m^{G2}$, $E_m^{G3}$ and $E_m^{G4}$ are diffraction fields of phase gratings composed of G1, G2, G3, and G4, respectively;

$$\begin{cases} E_m^{G1} = E_m\left(h_1/2, -h_1, f_1\right)\exp\left(-\mathrm{j}\frac{2m\pi}{d}x_1\right), \\[2mm] E_m^{G2} = E_m\left(\left(h_1 + h_2\right)/2, h_1 - h_2, f_2\right)\exp\left(-\mathrm{j}\frac{2m\pi}{d}x_2\right), \\[2mm] E_m^{G3} = E_m\left(\left(h_2 + h_3\right)/2, h_2 - h_3, f_3\right)\exp\left(-\mathrm{j}\frac{2m\pi}{d}x_3\right), \\[2mm] E_m^{G4} = E_m\left(h_4, 0, f_4\right)\exp\left(-\mathrm{j}\frac{2m\pi}{d}x_4\right), \end{cases}$$

wherein $h_1$, $h_2$, $h_3$ and $h_4$ represent heights of grating ridges in G1, G2, G3, and G4, respectively, $x_1$, $x_2$, $x_3$, and $x_4$ represent center positions of G1, G2, G3, and G4, respectively, and $f_1$, $f_2$, $f_3$, and $f_4$ represent duty cycles

of G1, G2, G3, and G4, respectively.

**10.** The method according to claim 5, wherein a weight vector $\{w_m\}$ of the diffraction order is orthogonal to a position error vector $\{\Delta x_m\}$, and a sum of $w_m$ is 1, so as to reduce an asymmetric position error.

A change range of an asymmetric grating structure is determined

An asymmetric grating simulation model is established

A position error of each diffraction order is simulated

A weight of each diffraction order is obtained

FIG. 1

FIG. 2

FIG. 3

Grating G

FIG. 4

FIG. 5

FIG. 6

FIG. 7

## INTERNATIONAL SEARCH REPORT

| International application No. |
| --- |
| **PCT/CN2021/118791** |

**A.   CLASSIFICATION OF SUBJECT MATTER**

G01B 11/00(2006.01)i;   G03F 9/00(2006.01)i

According to International Patent Classification (IPC) or to both national classification and IPC

**B.      FIELDS SEARCHED**

Minimum documentation searched (classification system followed by classification symbols)

G01B 11, G03F 9, G01D 5, G02B 5, G02B 27

Documentation searched other than minimum documentation to the extent that such documents are included in the fields searched

Electronic data base consulted during the international search (name of data base and, where practicable, search terms used)

CNTXT; CNABS; CNKI; ENTXT; VEN: 相位光栅, 位相光栅, 衍射光栅, 非对称, 不对称, 衍射, 级, 模型, 权重, 加权, phase grating?, diffraction grating?, asymmetric, asymmetry, diffraction, model, order, weight+

**C.      DOCUMENTS CONSIDERED TO BE RELEVANT**

| Category* | Citation of document, with indication, where appropriate, of the relevant passages | Relevant to claim No. |
| --- | --- | --- |
| Y | 杜聚有 等 (DU, Juyou et al.). "标记非对称变形导致的对准误差修正方法及其在套刻测量中的应用 (Calibration Method for Alignment Error Caused by Asymmetric Deformation of Mark and Its Application in Overlay Measurement)" 中国激光 (Chinese Journal of Lasers), Vol. 46, No. 7, 31 July 2019 (2019-07-31), ISSN: 0258-7025, pages 1-8, sections 1-3 | 1-5 |
| Y | CN 110967948 A (INSTITUTE OF MICROELECTRONICS OF CHINESE ACADEMY OF SCIENCES) 07 April 2020 (2020-04-07) description, paragraphs [0007]-[0026] | 1-5 |
| PX | CN 112833790 A (INSTITUTE OF MICROELECTRONICS OF CHINESE ACADEMY OF SCIENCES) 25 May 2021 (2021-05-25) claims 1-10 | 1-10 |
| A | CN 102460310 A (ASML NETHERLANDS B.V.) 16 May 2012 (2012-05-16) entire document | 1-10 |
| A | EP 1431833 A2 (ASML NETHERLANDS B.V.) 23 June 2004 (2004-06-23) entire document | 1-10 |

☑ Further documents are listed in the continuation of Box C.     ☑ See patent family annex.

| * Special categories of cited documents: | |
| --- | --- |
| "A"  document defining the general state of the art which is not considered to be of particular relevance | "T"  later document published after the international filing date or priority date and not in conflict with the application but cited to understand the principle or theory underlying the invention |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
| --- | --- |
| **09 November 2021** | **18 November 2021** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2021/118791** |

### C. DOCUMENTS CONSIDERED TO BE RELEVANT

| Category* | Citation of document, with indication, where appropriate, of the relevant passages | Relevant to claim No. |
| --- | --- | --- |
| A | CN 1879004 A (ACCENT OPTICAL TECHNOLOGIES INC.) 13 December 2006 (2006-12-13) <br> entire document | 1-10 |
| A | 戈亚萍 (GE, Yaping). "投影光刻中非对称型相位光栅对准信号及对准误差计算模型 (Model for the Calculation of Alignment Signal and Alignment Error of the Asymmetric Alignment Mark of Phase Grating in the Projection Lithography)" <br> 电子工业专用设备 *(Equipment for Electronic Products Manufacturing)*, <br> No. 208, 31 May 2012 (2012-05-31), <br> ISSN: 1004-4507, <br> pp. 19-23 | 1-10 |
| A | TAO ZHANG et al. "Influence of Asymmetric Grating Structures on Measurement Accuracy in Integrated Phase Grating Interference-Based metrology" <br> *Applied Optics,* Vol. 58, No. 7, 01 March 2019 (2019-03-01), <br> ISSN: 1559-874X, <br> pp. 1847-1854 | 1-10 |
| A | Erdmann A et al. "Computational Scanner Wafer Mark Alignment" <br> *Proceedings of SPIE,* 30 March 2017 (2017-03-30), <br> ISSN: 0277-786X, <br> pages 101471C-1 to 101471C-9 | 1-10 |

Form PCT/ISA/210 (second sheet) (January 2015)

INTERNATIONAL SEARCH REPORT
Information on patent family members

International application No.

**PCT/CN2021/118791**

| Patent document cited in search report | | | Publication date (day/month/year) | Patent family member(s) | | | Publication date (day/month/year) |
|---|---|---|---|---|---|---|---|
| CN | 110967948 | A | 07 April 2020 | None | | | |
| CN | 112833790 | A | 25 May 2021 | None | | | |
| CN | 102460310 | A | 16 May 2012 | TW | 201133161 | A | 01 October 2011 |
| | | | | TW | I447535 | B | 01 August 2014 |
| | | | | CN | 102460310 | B | 02 July 2014 |
| | | | | JP | 2012530366 | A | 29 November 2012 |
| | | | | JP | 5391333 | B2 | 15 January 2014 |
| | | | | US | 2010321654 | A1 | 23 December 2010 |
| | | | | US | 8767183 | B2 | 01 July 2014 |
| | | | | WO | 2010145951 | A2 | 23 December 2010 |
| | | | | WO | 2010145951 | A3 | 24 February 2011 |
| | | | | NL | 2004815 | A | 20 December 2010 |
| | | | | KR | 20120034716 | A | 12 April 2012 |
| | | | | KR | 101395733 | B1 | 15 May 2014 |
| EP | 1431833 | A2 | 23 June 2004 | EP | 1431833 | A3 | 15 April 2009 |
| CN | 1879004 | A | 13 December 2006 | JP | 2007505322 | A | 08 March 2007 |
| | | | | WO | 2005028992 | A2 | 31 March 2005 |
| | | | | WO | 2005028992 | A3 | 13 October 2005 |
| | | | | KR | 20060116797 | A | 15 November 2006 |
| | | | | KR | 101071654 | B1 | 11 October 2011 |
| | | | | EP | 1678466 | A2 | 12 July 2006 |
| | | | | EP | 1678466 | A4 | 30 July 2008 |

Form PCT/ISA/210 (patent family annex) (January 2015)